(19) Europäisches Patentamt
European Patent Office
Office européen des brevets

(11) **EP 4 560 332 B1**

(12) **EUROPEAN PATENT SPECIFICATION**

(45) Date of publication and mention
of the grant of the patent:
**21.01.2026 Bulletin 2026/04**

(21) Application number: **24208838.3**

(22) Date of filing: **25.10.2024**

(51) International Patent Classification (IPC):
**G01R 31/367** (2019.01)    **G01R 31/392** (2019.01)
**H01M 10/48** (2006.01)

(52) Cooperative Patent Classification (CPC):
**G01R 31/367; G01R 31/392; H01M 10/48**

(54) **METHOD AND SYSTEM FOR BATTERY CAPACITY PREDICTION**

VERFAHREN UND SYSTEM ZUR VORHERSAGE DER BATTERIEKAPAZITÄT

PROCÉDÉ ET SYSTÈME DE PRÉDICTION DE CAPACITÉ DE BATTERIE

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority: **22.11.2023 IN 202321079447**

(43) Date of publication of application:
**28.05.2025 Bulletin 2025/22**

(73) Proprietor: **Tata Consultancy Services Limited
Maharashtra (IN)**

(72) Inventors:
• **SAHU, SWATI**
**411057 Pune, Maharashtra (IN)**
• **BUDDHIRAJU, VENKATA SUDHEENDRA**
**411057 Pune, Maharashtra (IN)**
• **RAMANUJAM, MURALIKRISHNAN**
**411057 Pune, Maharashtra (IN)**
• **RUNKANA, VENKATARAMANA**
**411057 Pune, Maharashtra (IN)**

(74) Representative: **Goddar, Heinz J.
Boehmert & Boehmert
Anwaltspartnerschaft mbB
Pettenkoferstrasse 22
80336 München (DE)**

(56) References cited:
**WO-A1-2023/172735    US-A1- 2022 034 974
US-A1- 2022 149 645**

**Description**

CROSS-REFERENCE TO RELATED APPLICATIONS AND PRIORITY

The present application claims priority to Indian application no. 202321079447, filed on November 22, 2023.

TECHNICAL FIELD

The disclosure herein generally relates to battery management, and, more particularly, to a method and system for battery capacity prediction.

BACKGROUND

Battery capacity prediction models are important for commercial applications for several reasons. Firstly, accurate prediction of battery capacity allows for better battery management and optimization of battery usage. This is particularly important in commercial applications where batteries are used extensively, such as in electric vehicles and renewable energy grid storage systems. By accurately predicting battery capacity, it is possible to optimize charging and discharging cycles, extend battery life, and ensure reliable operation. Secondly, accurate capacity prediction models enable better battery health diagnosis and monitoring. By continuously monitoring the capacity of batteries, it is possible to detect early signs of degradation or failure. This allows for proactive maintenance and replacement of batteries, reducing the risk of unexpected failures and downtime in commercial applications. Furthermore, accurate capacity prediction models can aid in the design and development of battery systems. By predicting the future capacities and remaining useful life of batteries, it is possible to optimize the design of battery packs and select appropriate battery technologies for specific applications. This can lead to improved performance, cost savings, and increased efficiency in commercial applications. Moreover, accurate capacity prediction models can facilitate the development and commercialization of new battery technologies. By accurately predicting the capacity decay and cycle life of batteries, it is possible to evaluate the performance and reliability of new battery materials and designs. This can accelerate the development of novel electrode materials with larger capacities and longer lives, leading to advancements in battery technology for commercial applications.

Some of the major challenges are diverse aging mechanisms, significant device variability, and varied operating conditions of batteries, for example, that of lithium-ion batteries. These factors make it difficult to develop a generalized prediction model that can accurately capture the complex nature of battery degradation. The existing prediction methods often struggle to guarantee prediction accuracy due to the complex internal electrochemical reactions and external use conditions. The state-of-the-art models that can account for complex electrochemical reactions are typically physics-based pseudo two-dimensional (P2D) models. They can predict battery dynamics with maximum accuracy compared to all other existing models. However, some disadvantages of this approach are complexity and significant computational demand of Physics Based Models (PBMs), making them unsuitable for applications that provide instantaneous feedback. Document (US 2022/034974 A1) discloses a system or method for determining a battery state can include generating a set of models based on a measured response of a plurality of batteries to an applied load, measuring battery properties of a battery, and using a state estimator to determine a battery state associated with a battery (Abstract).

SUMMARY

Embodiments of the present disclosure present technological improvements as solutions to one or more of the above-mentioned technical problems recognized by the inventors in conventional systems. The invention is set out in appended set of claims.

It is to be understood that both the foregoing general description and the following detailed description are exemplary and explanatory only and are not restrictive of the invention, as claimed.

BRIEF DESCRIPTION OF THE DRAWINGS

The accompanying drawings, which are incorporated in and constitute a part of this disclosure, illustrate exemplary embodiments and, together with the description, serve to explain the disclosed principles:

FIG. 1 illustrates a framework for battery capacity prediction, according to some embodiments of the present disclosure.
FIG. 2 is a functional block diagram depicting components of an online module of a system of the framework of FIG. 1 for battery capacity prediction, according to some embodiments of the present disclosure.

FIG. 3 is a functional block diagram depicting components of an offline module of the system of the framework of FIG. 1 for battery capacity prediction, according to some embodiments of the present disclosure.

FIG. 4 illustrates components of the system for battery capacity prediction, according to some embodiments of the present disclosure.

FIG. 5 is a flow diagram depicting steps involved in the process of the battery capacity prediction by the system of FIG. 4, in accordance with some embodiments of the present disclosure.

FIG. 6 is a flow diagram depicting steps involved in the process of generating a dynamic OCV equation for the purpose of the battery capacity prediction, by the system of FIG. 4, in accordance with some embodiments of the present disclosure.

FIG. 7 is a block diagram depicting components of a dynamic OCV module of the system of FIG. 4, according to some embodiments of the present disclosure.

FIGS. 8 and 9 depict graphs of experimental data associated with the battery capacity prediction being performed by the system of FIG. 4, in accordance with some embodiments of the present disclosure.

FIG. 10 depicts an example implementation of a model selection module of the system of FIG. 1, in accordance with some embodiments of the present disclosure.

## DETAILED DESCRIPTION OF EMBODIMENTS

Exemplary embodiments are described with reference to the accompanying drawings. In the figures, the left-most digit(s) of a reference number identifies the figure in which the reference number first appears. Wherever convenient, the same reference numbers are used throughout the drawings to refer to the same or like parts. While examples and features of disclosed principles are described herein, modifications, adaptations, and other implementations are possible without departing from the scope of the disclosed embodiments.

Some of the major challenges from battery capacity prediction point of view are diverse aging mechanisms, significant device variability, and varied operating conditions of batteries, for example, that of lithium-ion batteries. These factors make it difficult to develop a generalized prediction model that can accurately capture the complex nature of battery degradation. The existing prediction methods often struggle to guarantee prediction accuracy due to the complex internal electrochemical reactions and external use conditions. The state-of-the-art models that can account for complex electrochemical reactions are typically physics-based pseudo two-dimensional (P2D) models. They can predict battery dynamics with maximum accuracy compared to all other existing models. However, some disadvantages of this approach are complexity and hence significant computational demand of PBMs, making them unsuitable for applications that demand provide instantaneous feedback.

In order to address these challenges, the embodiments disclosed herein provide a method and system for battery capacity prediction in which a Physics Based Model (PBM) is generated using the following approach. Initially, an input data comprising a battery specific information with respect to a battery is received. Further, the input data is pre-processed to generate a pre-processed data. Further, a set of features are generated from the pre-processed data. Further, a battery profile is created by mapping the pre-processed data to the set of features. Further, one or more models from a plurality of mechanistic and data-based models in a repository are selected based on the battery profile, wherein the one or more models are selected based on a major criterion. Further, a physics based model (PBM) is generated from an output data obtained from the selected one or more models. Further, a prediction of a set of state variables representing degradation of the battery is generated using the generated PBM model. By using this approach, i.e. by generating and using the physics based model, parameters that were not measurable by the state of the art approaches due to the complex nature of processes involved, are predicted, and is in turn used for the battery capacity prediction.

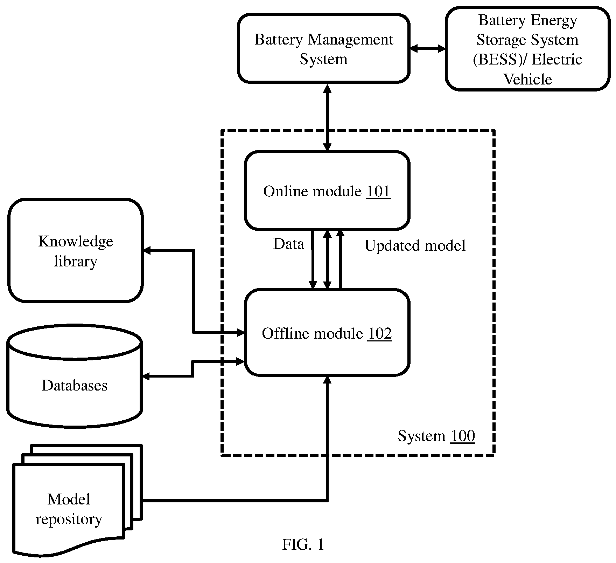

Referring now to the drawings, and more particularly to FIG. 1 through FIG. 10, where similar reference characters denote corresponding features consistently throughout the figures, there are shown preferred embodiments and these embodiments are described in the context of the following exemplary system and/or method.

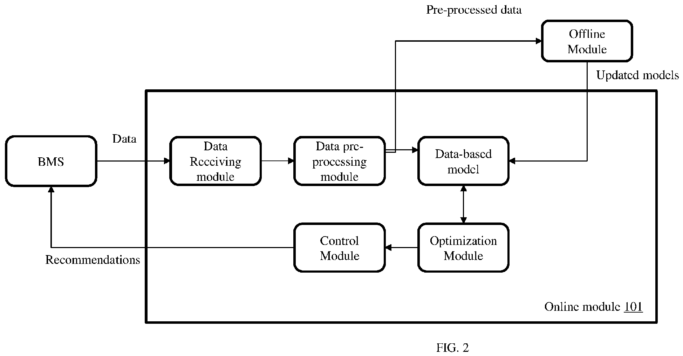

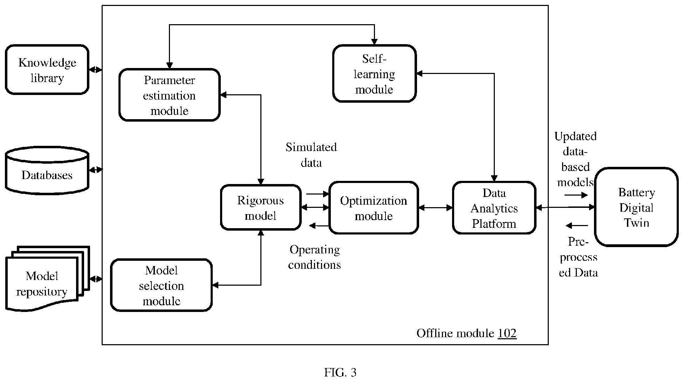

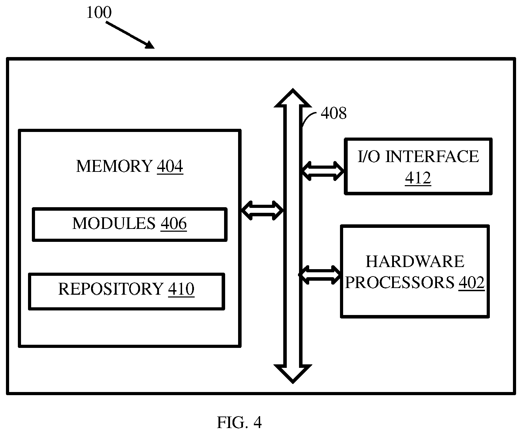

FIG. 1 illustrates a framework for battery capacity prediction, according to some embodiments of the present disclosure. As depicted, a battery management system (BMS) in the framework is in communication with a battery being monitored, i.e., for example, in the Battery Energy Storage System (BESS)/ Electric Vehicle. The BMS collects data such as but not limited to voltage, current, surface temperature, and resting period, from the battery and passes on to the system 100. The system 100 comprises of an offline module 102 and an online module 101 working in tandem for the purpose of predicting battery capacity of the battery. In an embodiment, the system 100 may, based on the predicted battery capacity, generate one or more recommendations towards optimizing performance of the battery so as to improve the battery capacity. The offline module 102 includes a model selection module, a parameter estimation module, a rigorous model, an optimization module, a data analytics platform, and a self learning module, as depicted in FIG. 3. The online module 101 includes a data receiving module, a data pre-processing module, a data based module, an optimization module, and a control module, as depicted in FIG. 2. of the system 100 are realized using the components depicted in FIG. 4, and are explained in hereafter.

FIG. 2 shows the sub-systems inside the online module 101. The battery maintenance system data is received by the data receiving module which then directs data towards the data pre-processing module. Data preprocessing involves detecting and eliminating outliers, filling in missing data, and harmonizing and incorporating multiple variables from one or more data origins. The data collected from different sources can be standardized, such as being uniformly sampled every minute. Real-time data is appropriately averaged, while non-real-time data is either interpolated or duplicated as needed. The pre-processed data is then directed to be used by the Data-based model to predict state variables such as State-of-Charge, State-of-health, etc. The Data-based model is computationally inexpensive and can run in real time. The Data-based models can be reduced order models or machine learning models. This data-based model is linked to the Optimization module that is used to determine optimal operating conditions to ensure longer cell life and safe operation. Based on the optimal conditions obtained from the optimization module, a control module provides feedback to the BMS. The Data-based model is updated periodically by the Offline Simulation module. As shown in FIG. 2, the offline simulation module receives the pre-processed data from the online module 101. It then uses the data to build and update the Data-based model.

FIG. 3 shows the schematic of the offline module 102. The main objective of this module is to update the models and parameters that are used in the 'Data-based model' of the online module 101. It does so by employing a data analytics platform. The data analytics platform uses the data received from the online module 101 to build and test these 'Data-based' models. The data received from the online module 101 may not be sufficient to build models, therefore, a physics-based model or PBM (shown as Rigorous model in FIG. 3) assists the platform by generating synthetic data for training and testing. The synthetic data is generated for different operating conditions. An optimization module directs the Rigorous model to simulate battery dynamics under various operating conditions.

The rigorous model is a customized physics-based model or PBM of cells used in BESS/EV to simulate the performance of cell at different operating conditions. This customized PBM is generated with the help of 'Model selection module' and 'Parameter Estimation" module. Description of each of these modules is provided below:

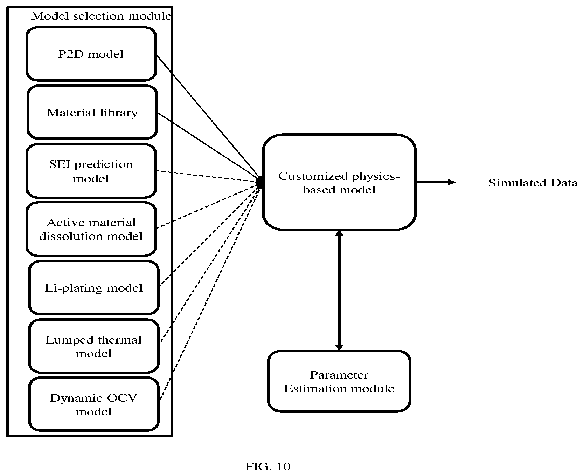

The Parameter Estimation module assists the PBM estimation of parameters that are not present in a material library(as depicted in FIG. 10). The Parameter estimation module also utilizes information from various database as well as Knowledge library to estimate parameters. The parameter estimation module conducts a sensitivity analysis of parameters by creating sensitivity value matrices that illustrate how the model's output varies as parameters change under different operating conditions. Subsequently, the parameters are categorized into four clusters using a fuzzy clustering method, which identifies the parameters with the highest sensitivity and easiest identifiability.. Alternatively, the parameter estimation can also be performed using multi-objective optimization methods. Terminal voltage and surface temperature curves can be used as identification objectives. Pareto fronts obtained using the multi-objective optimization algorithms (such as Non Dominated Sorting Genetic Algorithm (NSGA-II algorithm)) and a multiple criteria decision making method (such as Technique for Order of Preference by Similarity to Ideal Solution (TOPSIS)) is used to select the final identification result. The parameters are finalized when the simulated data using the final parameter identification results are in good agreement with the experimental data of battery.

The model selection module is used to specify the sub-models that should be included to build a customized physics-based model. This module aims to minimize computational requirement as well as complexity of the PBM while maintaining a reasonable level of accuracy. It does so by identifying all predominant mechanisms that have substantial impact on cell performance and incorporating models solely for these dominant mechanisms, disregarding other models.

The self-learning module is configured to monitor the performance of the physics - based and data - driven models and retune/retrain the models in case of a drift in their performance. For the PBM, tunable parameters such as intercalation reaction rates, species reaction rates, heat transfer coefficients, specific heat capabilities of various species, etc., are re-tuned in case of performance drift. For data-based models generated through Data Analytics platform, either the hyper-parameters of the models are re-tuned, or models are re-trained in case of a performance drift. The re-tuned and re-trained models are stored in the model repository.

The optimization module is configured to optimize a plurality of performance indicators such as charging time, state-of-health, etc. The optimization module further comprises of an optimization configuration module and an optimization execution module. The optimization configuration module is configured to enable configuring of optimization models / optimizer specific to the battery pack. The optimizer may be configured after a predefined time interval, when the performance indicators cross the predefined thresholds. Configuration of the optimization problem involves choosing the type of optimization problem (single objective vs multi objective), direction of optimization (maximize or minimize), one or more objective functions, one or more constraints and their lower and upper limits. The optimization execution module is configured to solve the optimization models saved using the optimization configuration module. The optimization execution module utilizes a plurality of optimization solvers to generate one or more recommendations for operating conditions to be simulated using the PBM.

The Rigorous model (PBM) is used for simulating cell dynamics at a specified operating condition. Specifying operating conditions means specifying initial voltage, current, ambient temperature, charging & discharging scheme, and resting period. The PBM is used for predicting state variables such as state-of-charge (SoC), state-of-health (SoH) and other battery dynamic variables such as discharging profile, capacity fade, concentration profiles, SEI resistance, open-circuit voltage (OCV), etc. The PBM in the offline module 102 can capture phenomena such as current-voltage hysteresis and time-dependent performance evolution, which are not easily captured by data-based models. The PBM also allows investigation of various operating conditions and the optimization of cell design and performance. The predicted variables such as SoC, SoH, charge/discharge profile from offline module 102 are used to update the data-based models of Battery Digital Twin at specific time intervals.

The governing equations used in PBM for simulating Li-ion cell dynamics are based on the principles of porous electrode theory, concentrated solution theory, and appropriate kinetics equations that are applied in P2D (pseudo-two-dimensional) framework. These equations capture the electrochemical, electrical, and thermal processes occurring within the cell. The PBM-P2D model considers the spatial distribution of electrochemical potentials and lithium-ion concentrations perpendicular to the current collectors, as well as the electrical potential along the current collectors and the local temperature within the battery. The model accounts for mass transport, charge transfer kinetics, and ohmic losses, providing a comprehensive understanding of the cell's behavior. This involves solving a combination of differential algebraic equations (DAEs), ordinary differential equation (ODEs) and partial differential equation (PDEs) representing various physical processes inside the cell. Solving these equations requires computational resources that may or may not be included in the online module 101, depending on the computational resource available on-premises. For mobility applications, such as EV, the offline module 102 can be cloud based. Whereas, for grid storage BESS, the offline module 102 can be deployed on-premises.

The components of the online module 101 and the offline module 102 are implemented using hardware processors 402, at least one memory such as a memory 404, and an I/O interface 412 as depicted in FIG. 4. The hardware processors 402, memory 404, and the Input /Output (I/O) interface 412 may be coupled by a system bus such as a system bus 408 or a similar mechanism. In an embodiment, the hardware processors 402 can be one or more hardware processors.

The I/O interface 412 may include a variety of software and hardware interfaces, for example, a web interface, a graphical user interface, and the like. The I/O interface 412 may include a variety of software and hardware interfaces, for example, interfaces for peripheral device(s), such as a keyboard, a mouse, an external memory, a printer and the like. Further, the I/O interface 412 may enable the system 100 to communicate with other devices, such as web servers, and external databases.

The I/O interface 412 can facilitate multiple communications within a wide variety of networks and protocol types, including wired networks, for example, local area network (LAN), cable, etc., and wireless networks, such as Wireless LAN (WLAN), cellular, or satellite. For the purpose, the I/O interface 412 may include one or more ports for connecting several computing systems with one another or to another server computer. The I/O interface 412 may include one or more ports for connecting several devices to one another or to another server.

The one or more hardware processors 402 may be implemented as one or more microprocessors, microcomputers, microcontrollers, digital signal processors, central processing units, node machines, logic circuitries, and/or any devices that manipulate signals based on operational instructions. Among other capabilities, the one or more hardware processors 402 is configured to fetch and execute computer-readable instructions stored in the memory 404.

The memory 404 may include any computer-readable medium known in the art including, for example, volatile memory, such as static random-access memory (SRAM) and dynamic random-access memory (DRAM), and/or non-volatile memory, such as read only memory (ROM), erasable programmable ROM, flash memories, hard disks, optical disks, and magnetic tapes. In an embodiment, the memory 404 includes a plurality of modules 406.

The plurality of modules 406 include programs or coded instructions that supplement applications or functions performed by the system 100 for executing different steps involved in the process of the battery capacity prediction, being performed by the system 100. The plurality of modules 406, amongst other things, can include routines, programs, objects, components, and data structures, which performs particular tasks or implement particular abstract data types. The plurality of modules 406 may also be used as, signal processor(s), node machine(s), logic circuitries, and/or any other device or component that manipulates signals based on operational instructions. Further, the plurality of modules 406 can be used by hardware, by computer-readable instructions executed by the one or more hardware processors 402, or by a combination thereof. The plurality of modules 406 can include various sub-modules (not shown). The plurality of modules 406 may include computer-readable instructions that supplement applications or functions performed by the system 100 for the battery capacity prediction.

The data repository (or repository) 410 may include a plurality of abstracted piece of code for refinement and data that is processed, received, or generated as a result of the execution of the plurality of modules in the module(s) 406.

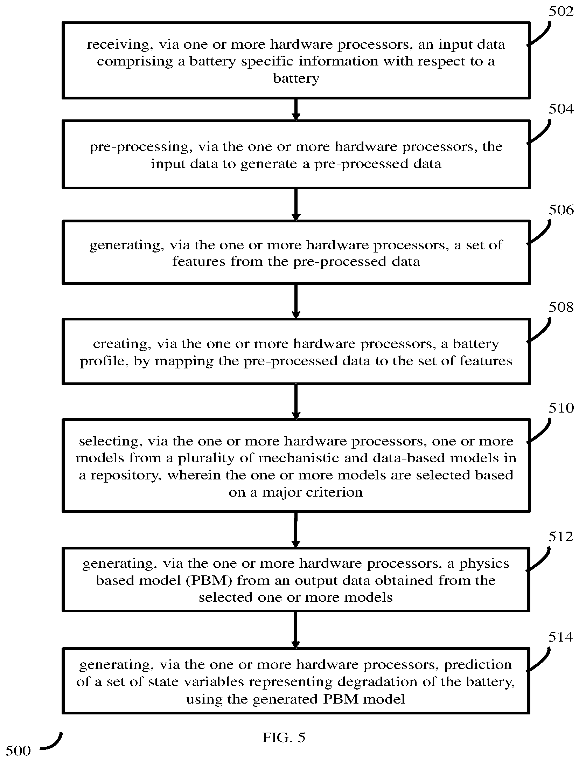

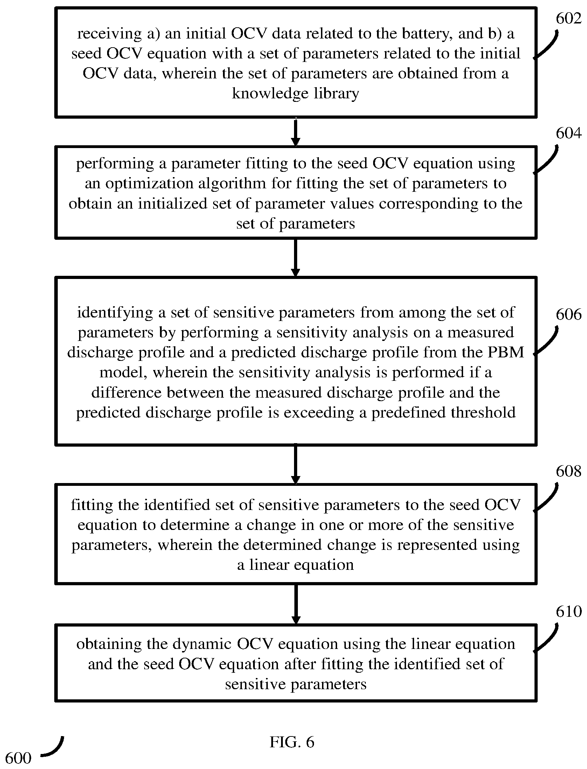

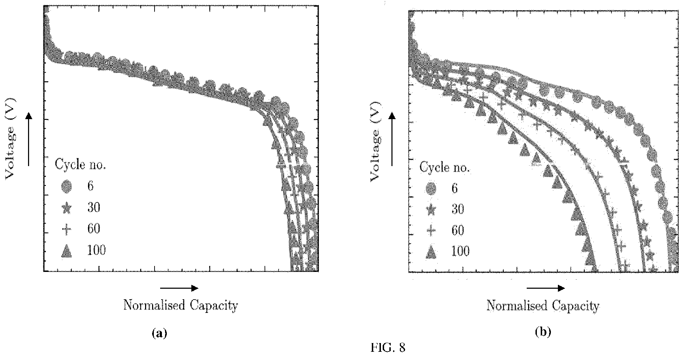

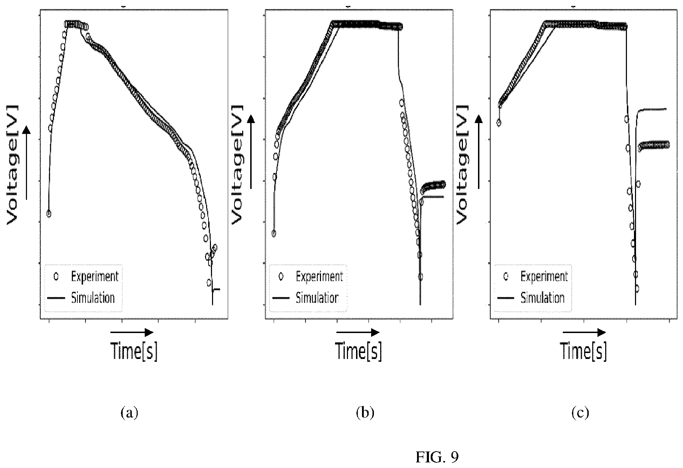

Although the data repository 410 is shown internal to the system 100, it will be noted that, in alternate embodiments, the data repository 410 can also be implemented external to the system 100, where the data repository 410 may be stored within a database (repository 410) communicatively coupled to the system 100. The data contained within such external database may be periodically updated. For example, new data may be added into the database (not shown in FIG. 4) and/or existing data may be modified and/or non-useful data may be deleted from the database. In one example, the data may be stored in an external system, such as a Lightweight Directory Access Protocol (LDAP) directory and a Relational Database Management System (RDBMS). Functions of the components of the system 100 are now explained with reference to the steps in flow diagrams in FIG. 5 and FIG. 6, the components in FIG. 3, FIG. 4, and FIG. 7, the graphs in FIGS. 8 and 9, and the diagram in FIG. 10.

FIG. 5 is a flow diagram depicting steps involved in the process of the battery capacity prediction by the system of FIG. 4, in accordance with some embodiments of the present disclosure.

In an embodiment, the system 100 comprises one or more data storage devices or the memory 404 operatively coupled to the processor(s) 402 and is configured to store instructions for execution of steps of the method 200 by the processor(s) or one or more hardware processors 402. The steps of the method 200 of the present disclosure will now be explained with reference to the components or blocks of the system 100 as depicted in FIG. 4 and the steps of flow diagram as depicted in FIG. 5. Although process steps, method steps, techniques or the like may be described in a sequential order, such processes, methods, and techniques may be configured to work in alternate orders. In other words, any sequence or order of steps that may be described does not necessarily indicate a requirement that the steps to be performed in that order. The steps of processes described herein may be performed in any order practical. Further, some steps may be performed simultaneously.

At step 502 of method 500 of FIG. 5, the system 100 receives an input data comprising a battery specific information with respect to a battery. In an embodiment of the method, the battery specific information received as input data comprises of a) electrode chemistry, b) electrolyte chemistry, c) operating voltage range, d) operating temperature range, e) operating pressure range, f) an initial State of Charge (SOC), and g) an influential degradation mechanism associated with the battery. As detailed above, the data maybe received from the associated BMS which is in communication with the battery. **In** an alternate embodiment, the system 100 may be in direct communication with the battery via appropriate interfaces and sensors, to collect details on various parameters such as but not limited to the voltage, current, surface temperature, and the resting period.

Further, at step 504 of the method 500, the system 100 pre-processes the input data to generate a pre-processed data. The data preprocessing may involve detecting and detecting and eliminating outliers, data cleaning, filling in missing data, data imputation, and harmonizing and incorporating multiple variables from one or more data origins. Further, data that is collected from different sources are standardized as part of the preprocessing, for example, by uniformly sampling every minute. During the preprocessing, the system 100 may appropriately average the real-time data, while non-real-time data is either interpolated or duplicated as needed.

Further, at step 506 of the method 500, the system 100 generates a set of features from the pre-processed data. For example, the set of features generated from the preprocessed data may include anode material, cathode material, electrolyte material, operating voltage range, operating temperature range, and operating pressure range. In an embodiment, the system 100 may any standard feature generation approach/technique involving the steps of feature selection (either through tree-based model or any other relevant method), feature encoding (e.g., One-hot encoding), feature scaling, and feature extraction, so as to generate the set of features from the preprocessed data. At this step, the system 100 creates categorical features for anode material and cathode material, and numerical features for remaining aspects. An example of anode material category is "Graphite" and "Lithium metal". These features are mapped to each sub-models based on source information. For example, the data collected from different resources may mention SEI growth and Li-plating as major degradation mechanism, and "graphite" anode and "LCO" cathode. Then, the feature dataset is mapped to both "SEI prediction" sub-model and "Li-plating" sub-model and are not mapped to other sub-models.

Further, at step 508 of the method 500, the system 100 creates a battery profile for the battery being monitored, by mapping the pre-processed data to the set of features. The battery profile represents various characteristics of the battery. A few examples of the characteristics are, but not limited to, charging/discharging characteristics, State of Charge (SoC), and State of Health (SoH), of the battery. For example, if the generated data indicates the battery chemistry as Graphite anode, NMC cathode, operating temperature as 25°C-35°C and operating voltage as 3.5V-4.2V. Then the system 100 maps the features to create the battery profile as:

- Anode Material= "Graphite"
- Cathode Material= "NMC"
- Lowest operating voltage= 3.5
- Highest operating voltage= 4.2
- Lowest operating temperature= 25
- Highest operating temperature= 35

Further, at step 510 of the method 500, the system 100 selects one or more models from a plurality of mechanistic and data-based models in a repository, wherein the one or more models are selected based on a major criterion. The major criteria is based on a dominant physical or chemical process inside the battery. A dominant process can depend on the type of cell and operating condition. Each of the plurality of mechanistic and data-based models represents one or more physical/chemical process that can be dominating in some case, i.e., each model has a unique major criteria. In an embodiment, the major criteria is assigned to each model while designing the model selection logic, i.e., hard-coded. The system 100 compares the dominant process in the battery being analyzed, which is determined based on the data in the battery profile, with the major criteria of each of the plurality of mechanistic and data-based models, and all models having the matching major criterion are selected.

Further, at step 512 of the method 500, the system 100 generates a physics based model (PBM) from an output data obtained from the selected one or more models. At this stage, the system 100 uses data generated or predicted by the PBM, and uses this information as training data to generate the data-based models through data analytics platform.

In an embodiment, the generated PBM may be considered as a customized PBM, as the system 100 selects the one or more models that contribute to the PBM. Some examples of the mechanistic and data models that may be used by the system 100 at this stage are depicted in the example diagram in FIG. 10. As depicted the one or more data models may include a P2D model, a material library, a SEI prediction model, an active material dissolution model, a Li-plating model, a lumped thermal model, and a dynamic OCV model. Details of these models are given below:

a. The P2D model includes one or more differential algebraic equations (DAEs) that represent conservation laws for mass and charge transport within the battery. These equations describe the spatial distribution of electrochemical potentials and lithium-ion concentrations perpendicular to the current collectors. They also account for the transport of lithium ions through the porous electrode and the electrolyte. They capture the spatial and temporal variations of key variables, such as lithium-ion concentration, electrochemical potential, electrical potential, enabling detailed analysis of cell behavior under different operating conditions. In an embodiment, this model may be a mandatory component in the PBM model.

b. The material library contains information related to various physical and chemical properties of electrode and electrolyte materials that are required to build a PBM. These properties include diffusivity, ionic conductivity, electrical conductivity, thermal conductivity, etc. Apart from these properties, an important parameter set required for PBM is the half-cell open circuit voltage (OCV) data of individual electrode. The material library contains this data for common electrolyte and electrolyte materials. In an embodiment, the material library also may be a mandatory component in the PBM model.

c. During the charge, most of the lithium in the positive electrode leaves the host structure and goes into the host structure of the negative electrode. The negative electrode is usually made of graphite. However, during the first lithiation the potential decreases and the electrolyte reacts with the carbon on the surface creating new compounds and releasing gas. This process is accompanied by a non-reversible consumption of lithium ions that remain trapped in these compounds. Thus, the surface of the active material is covered with solid electrolyte interface (SEI). This layer is composed of a mixture of lithium carbonates and many other complex compounds. Fortunately, it constitutes a barrier between the active material and the electrolytes, preventing further reactions between the electrode and the electrolyte. However, the SEI (that is mostly formed during the first charge of the battery), could be broken up and it is subject to degradation due to both current and temperature cycling. Consequently, the SEI is re-formed at each time that the electrode's surface is directly exposed to the electrolyte. These details are captured in the SEI prediction model.

d. Active material dissolution model accounts for the loss of electrode active material during cell operation. Major factor for active material dissolution of positive electrode particle is the reaction of active material with acid. The acid is produced due to decomposition of salts present in electrolyte and due to electrolyte oxidation at high voltage (>4.2V). The dissolved active material transfers through the electrode and deposits on the surface of negative electrode resulting in reduction in active surface area. A part of dissolved active material also gets re-deposited on the surface of positive electrode material, further reducing the active surface area. These factors are accounted for in the Active material dissolution model.

e. Li-plating model: Li-plating is one of the most detrimental aging mechanisms in Lithium-ion Batteries. During fast charging, Li+ ions from the electrolyte can be deposited on the surface of the negative electrode rather than being intercalated into the interstitial space between the anode's atomic layers. It mostly occurs under conditions that slow down the main intercalation reaction, such as low temperatures or when the surface of the anode is fully lithiated, favoring the competing Li-plating reaction. The Li-plating reaction can be either reversible or irreversible. The irreversibly deposited lithium can sometimes react with electrolyte to form a secondary SEI layer. SEI growth over the plated Li results in parts of the Li metal deposit to become electrically isolated, forming "dead lithium" that cannot be recovered. This high resistance dead lithium film increases internal resistance and decreases energy density. These details are captured in the Li-plating model.

f. Lumped thermal model contains energy balance equation for accounting heat generation due to ohmic loss, heat generation due to reversible reaction and heat generation due to electrochemical reaction.

g. Dynamic OCV module: Open circuit Voltage (OCV) is an important function parameter that is required for modeling Li-ion cell in PBM. The open-circuit voltage (OCV) of an electrode can change during cell cycling. This change in OCV is often associated with electrode degradation and can provide important indications of the electrode's performance and lifetime. This model captures related details.

As depicted in FIG. 10, the model selection module of the system 100 may choose any combination of these models and form the PBM.

The PBM is then used by the system 100 for generating a prediction of a set of state variables representing degradation of the battery. The system 100 predicts the set of state variables by solving a set of mass conservation and charge conversation equations using the PBM. Some examples of the set of mass conservation and charge conversation equations used by the system 100 are given below:

The charge balance equation in the solid phase is given by Ohm's law:

$$\sigma_{eff,k} \frac{\delta^2 \varphi_{s,k}(x,t)}{\delta x^2} = a_k F J_k(x,t) \qquad \text{--- (1)}$$

Where $\sigma_{eff}$ is effective electronic conductivity of the solid phase of electrode (S/m), $\varphi_s$ is the solid-phase potential of electrode (V), $a_k$ is the specific surface area of the electrode (1/m), $F$ is Faraday's constant (C/mol) and $J_k$ is the wall flux of Li+ on the particles of electrode (mol/m²s). The subscript $k$ represents electrode (k = p, n)

The charge balance in the solution phase is:

$$-\sigma_{eff,k} \frac{\delta \varphi_{s,k}(x,t)}{\delta x} - \kappa_{eff,k} \frac{\delta \varphi_{e,k}(x,t)}{\delta x} + \frac{2\kappa_{eff,k} RT}{F}\left(1 - t_+\right) \frac{\partial \ln c_{e,k}}{\partial x} = I$$

$$\text{--- (2)}$$

Where $\kappa_{eff}$ is effective ionic conductivity of the electrolyte (S/m), $\varphi_e$ is the electrolyte potential, $R$ is gas constant (V), $t+$ is the transference number, $c_e$ is the concentration of electrolyte (mol/m³) in the region k (k=p,n,s); I is the applied current density (A/m²)

The Li-ion concentration in the cell by the following mass balance equation:

$$\varepsilon_k \frac{\partial c_{e,k}(x,t)}{\partial t} = \frac{\partial}{\partial x}\left(D_{eff,k} \frac{\partial c_{e,k}(x,t)}{\partial x}\right) + a_k(1 - t_+)J_k(x,t)$$

$$\text{--- (3)}$$

Where $\varepsilon_k$ is the porosity, $D_{eff}$ is the effective diffusion coefficient of Li+ in electrolyte in the region k (k=p,n,s)

The solid phase concentration of Li+ ions $(c_s)$ in electrode phase is governed by Fick's law (2D):

$$\frac{\partial c_{s,k}(x,r,t)}{\partial t} = \frac{D_{s,k}}{r^2}\frac{\partial}{\partial r}\left(r^2 \frac{\partial c_{s,k}(x,r,t)}{\partial r}\right) \qquad \text{--- (4)}$$

Where $D_s$ is the Li+ diffusion co-efficient in the solid electrolyte. The flux $J_k$, representative of the reaction at particle surface, is governed by the Butler Volmer kinetics :

$$J_k(x,t) = K_k\left(c_{s,k}^{max} - c_{s,k}^{surf}\right)^{0.5}\left(c_{s,k}^{surf}\right)^{0.5}\left(c_{e,k}\right)^{0.5}\left[exp\left(\frac{0.5F\mu_{s,k}(x,t)}{RT}\right) - \right.$$

$$\left. exp\left(-\frac{0.5F\mu_{s,k}(x,t)}{RT}\right)\right]$$

$$\text{--- (5)}$$

Where K is the rate constant for intercalation/deintercalation (mol$^{0.5}$ m$^{2.5}$ s$^{-1}$), $c_s^{max}$ is the maximum solid phase lithium concentration in the electrode (mol/m³), $c_s^{surf}$ is the surface concentration of lithium at the surface of electrode (mol/m³), $c_e$ is the liquid phase Li+ concentration (mol/m³), $\mu_s$ is the overpotential (V). The overpotential is calculated by:

$$\mu_s = \varphi_s - \varphi_e - U_k \qquad \text{--- (6)}$$

$U_i$ is the open-circuit potential.

The state variables are calculated from the independent variables. For example, SoC is the ratio of current Li concentration and maximum Li concentration of the electrode. SoH and RUL are calculated from post-processing of simulation results such as reduction in active species, reduction in discharging/charging time and value of resistances.

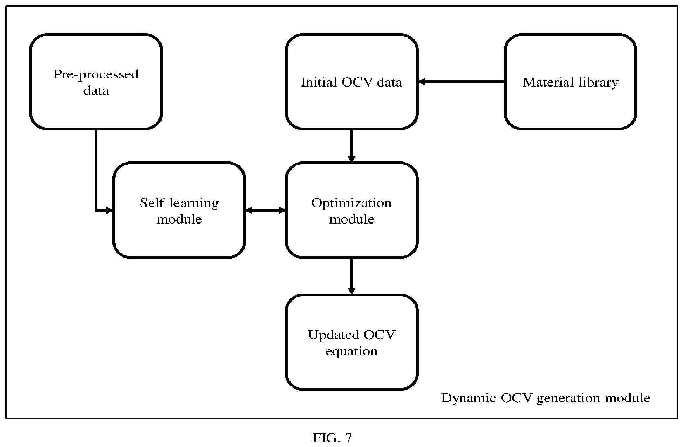

The set of variables comprise of state-of-charge (SoC), state-of-health (SoH), remaining useful life (RUL) and a set of dynamic variables, and wherein the set of dynamic variables comprises of a discharge profile, capacity fade, one or more concentration profiles, film resistances, change in diffusivity, change in volume fraction of active material, change in internal temperature, change in material properties, and Open-Circuit Voltage (OCV). In an embodiment, the OCV is predicted using dynamic OCV equation generated a dynamic OCV generation module (not shown in FIG. 1) of the system 100. Components of the dynamic OCV generation module are depicted in FIG. 7. As depicted, the dynamic OCV generation module includes a self-learning data, and an optimization module. Various steps involved in the process of generating the dynamic OCV equation are depicted in method 600 in FIG. 6, and are explained hereafter.

At step 602 of the method 600, the system 100 receives a) an initial OCV data related to the battery, and b) a seed OCV equation with a set of parameters related to the initial OCV data, from a knowledge library associated with the repository 410. The seed OCV equation is a nonlinear equation, and may be of the format:

$$V_{oc} = a + b\,\tanh(-cx + d) - e\left(\frac{1}{(f-x)^g} - h\right) - i\,\exp\left(-j(x^k)\right)$$
$$+ l\,\exp\left(-mx - 0.n\right)$$

$$\text{--- (7)}$$

Where, x is SoC of the electrode and parameters a,b,c.. n are fitted parameters.

Further, at step 604 of the method 600, the system 100 performs a parameter fitting to the seed OCV equation using an optimization algorithm for fitting the set of parameters to obtain an initialized set of parameter values corresponding to the set of parameters. After the parameter fitting, (7) can be rewritten as:

$$V_{oc\_} = 4.12 + 0.02\,\tanh(-18.08x + 7.66) - 0.02\left(\frac{1}{(0.99-x)^{0.54}} - 1.79\right)$$
$$- 0.13\,\exp\left(-0.17(x^{11.34})\right) + 0.81\,\exp\left(-61.02x - 0.72\right)$$

Further, at step 606 of the method 600, the system 100 identifies a set of sensitive parameters from among the set of parameters by performing a sensitivity analysis on a measured discharge profile and a predicted discharge profile from the PBM model, wherein the sensitivity analysis is performed if a difference between the measured discharge profile and the predicted discharge profile is exceeding a predefined threshold. The sensitivity analysis identifies one or more parameters that correspond to the change in OCV. For determining the change in OCV, the system 100 may normalize the discharge profile with measured capacity (V_oc_expected).

Further, at step 608 of the method 600, the system 100 fits the identified set of sensitive parameters to the seed OCV equation to determine a change in one or more of the sensitive parameters. Further, a linear equation is used to represent the determined change. The linear equation is used along with the seed OCV equation after fitting the one or more sensitive parameters, to obtain the dynamic OCV equation.

. For example, consider that in the above example the sensitivity analysis detected two parameters that have maximum sensitivity to the changes in OCV. Then after fitting the identified set of sensitive parameters and performing the linear interpolation, (8) can be rewritten as:

$$V_{oc\_updated} = 4.12 + 0.02\,\tanh(-18.08x + 7.66)$$
$$- e_{param}\left(\frac{1}{(0.99-x)^{0.54}} - 1.79\right)$$
$$- i_{param}\,\exp\left(-0.17(x^{11.34})\right) + 0.81\,\exp\left(-61.02x - 0.72\right)$$

where, e_parameter and i_parameter are the identified sensitive parameters.

An optimization code is used to determine the values of sensitive parameters that would fit the expected OCV.

Using this new optimized value of the sensitive parameters, the initial value of these sensitive parameters and a time elapsed from the start of cell operation, time-dependent expression for these sensitive parameters are derived. For example, for the above case, the expression for e_parameter and i_parameter are shown below:

$$e_{parameter} = 0.15 + 2.98e^{-7}t$$

$$i_{parameter} = 0.13 + 3.10e^{-7}t$$

The derived expression for the sensitive parameters are then used by the system 100 in the updated OCV equation. In the aforementioned example, V_oc_updated is generated as:

$$V_{oc\_updated} = 4.12 + 0.02 \tanh(-18.08x + 7.66) - (0.15$$
$$+ 2.98e^{-7}t) \left(\frac{1}{(0.99 - x)^{0.54}} - 1.79\right) - (0.13$$
$$+ 3.10e^{-7}t) \exp\left(-0.17(x^{11.34}) + 0.81 \exp\left(-61.02x\right.$$
$$- 0.72\right)$$

In an embodiment, a set of data based models in the online module 101 are updated using the predicted set of state variables, wherein the set of data based models predicts in real time a set of real time state variables.

FIGS. 8 and 9 depict graphs of experimental data associated with the battery capacity prediction being performed by the system of FIG. 4, in accordance with some embodiments of the present disclosure.

FIG. 8 corresponds to simulation data of a Li-ion cell with configuration anode material=Li-metal and cathode material=LiMn2O4, which has been simulated at two different ambient temperatures for 100 charge/discharge cycles. A customized PBM was created using the mandatory modules (P2D module and material library) as well as modules selected through major criteria: Active material dissolution (ACM) and Dynamic OCV module. Here, the major criterion for ACM module was cathode material which should be Mn-based cathode. The major criteria for dynamic OCV model is the temperature range which is greater than 25 deg C. (a) of FIG. 8 shows the discharge profile of cell at an ambient temperature of 25 degree Celsius for 100 charge discharge cycles. (b) of FIG. 8 shows the discharge profile of cell at an ambient temperature of 55 degree Celsius 100 charge/discharge cycles. In (a) and (b) of FIG. 8, symbols represent experimental data as reported in literature and lines represent simulated results. Experimental and simulated results were found to be in agreement.

FIG. 9 corresponds to simulation data of a Li-ion cell with configuration Graphite/NMC 811, which has been simulated for three different charging rates (0.05C, 1C and 2C) rates at a low ambient temperature (5 degree Celsius). A customized PBM was created using the mandatory modules (P2D module and material library) as well as modules selected based on major criteria: SEI prediction module and Li-plating module. Here, major criterion for Li-plating module is the temperature range which is below 20 degree C and the major criterion for SEI module is the anode material which is 'graphite'. Sub-figures (a), (b) and (c) in FIG. 9 show the simulated voltage variation vs time of the cell with respect to measured experimental data from literature at charging rate of 0.05C, 1C and 2C respectively.

The written description describes the subject matter herein to enable any person skilled in the art to make and use the embodiments. The scope of the subject matter embodiments is defined by the claims and may include other modifications that occur to those skilled in the art. Such other modifications are intended to be within the scope of the claims if they have similar elements that do not differ from the literal language of the claims or if they include equivalent elements with insubstantial differences from the literal language of the claims.

The embodiments of present disclosure herein address unresolved problem of battery capacity prediction. The embodiment, thus provides a mechanism to generate a Physics Based Model (PBM) for the battery capacity prediction. Moreover, the embodiments herein further provide mechanism for predicting the capacity of the battery using the PBM.

It is to be understood that the scope of the protection is extended to such a program and in addition to a computer-readable means having a message therein; such computer-readable storage means contain program-code means for implementation of one or more steps of the method, when the program runs on a server or mobile device or any suitable programmable device. The hardware device can be any kind of device which can be programmed including e.g., any kind of computer like a server or a personal computer, or the like, or any combination thereof. The device may also include means which could be e.g., hardware means like e.g., an application-specific integrated circuit (ASIC), a field-programmable gate array (FPGA), or a combination of hardware and software means, e.g., an ASIC and an FPGA, or at least one microprocessor and at least one memory with software processing components located therein. Thus, the means can include both hardware means and software means. The method embodiments described herein could be implemented in hardware and software. The device may also include software means. Alternatively, the embodiments may be implemented on different hardware devices, e.g., using a plurality of CPUs.

The embodiments herein can comprise hardware and software elements. The embodiments that are implemented in software include but are not limited to, firmware, resident software, microcode, etc. The functions performed by various components described herein may be implemented in other components or combinations of other components. For the purposes of this description, a computer-usable or computer readable medium can be any apparatus that can comprise, store, communicate, propagate, or transport the program for use by or in connection with the instruction execution system, apparatus, or device.

The illustrated steps are set out to explain the exemplary embodiments shown, and it should be anticipated that ongoing technological development will change the manner in which particular functions are performed. These examples are presented herein for purposes of illustration, and not limitation. Further, the boundaries of the functional building blocks have been arbitrarily defined herein for the convenience of the description. Alternative boundaries can be defined so long as the specified functions and relationships thereof are appropriately performed. Alternatives (including equivalents, extensions, variations, deviations, etc., of those described herein) will be apparent to persons skilled in the relevant art(s) based on the teachings contained herein. Such alternatives fall within the scope of the disclosed embodiments. Also, the words "comprising," "having," "containing," and "including," and other similar forms are intended to be equivalent in meaning and be open ended in that an item or items following any one of these words is not meant to be an exhaustive listing of such item or items, or meant to be limited to only the listed item or items. It must also be noted that as used herein and in the appended claims, the singular forms "a," "an," and "the" include plural references unless the context clearly dictates otherwise.

Furthermore, one or more computer-readable storage media may be utilized in implementing embodiments consistent with the present disclosure. A computer-readable storage medium refers to any type of physical memory on which information or data readable by a processor may be stored. Thus, a computer-readable storage medium may store instructions for execution by one or more processors, including instructions for causing the processor(s) to perform steps or stages consistent with the embodiments described herein. The term "computer-readable medium" should be understood to include tangible items and exclude carrier waves and transient signals, i.e., be non-transitory. Examples include random access memory (RAM), read-only memory (ROM), volatile memory, nonvolatile memory, hard drives, CD ROMs, DVDs, flash drives, disks, and any other known physical storage media.

It is intended that the disclosure and examples be considered as exemplary only, with a true scope of disclosed embodiments being indicated by the following claims.

## Claims

1. A processor implemented method (500), comprising:

receiving (502), via one or more hardware processors, an input data comprising a battery specific information with respect to a battery;
pre-processing (504), via the one or more hardware processors, the input data to generate a pre-processed data;
generating (506), via the one or more hardware processors, a set of features from the pre-processed data;
creating (508), via the one or more hardware processors, a battery profile, by mapping the pre-processed data to the set of features, selecting (510), via the one or more hardware processors, one or more models from a plurality of mechanistic and data-based models in a repository, wherein the one or more models are selected based on a major criterion and data in the battery profile;
generating (512), via the one or more hardware processors, a physics based model (PBM) from an output data obtained from the selected one or more models; and
generating a set of state variables representing degradation of the battery using the generated PBM model, wherein the set of state variables comprise of state-of-charge (SoC), state-of-health (SoH), remaining useful life (RUL) and a set of dynamic variables, and the set of dynamic variables comprises of a discharge profile, capacity fade, one or more concentration profiles, film resistances, change in diffusivity, change in volume fraction of active material, change in internal temperature, change in material properties, and Open-Circuit Voltage (OCV), wherein the OCV is predicted using a dynamic OCV equation generated via the one or more hardware processors, **characterised in that**: generating the dynamic OCV equation comprises:

receiving (602) a) an initial OCV data related to the battery, and b) a seed OCV equation with a set of parameters related to the initial OCV data, wherein the set of parameters are obtained from a knowledge library;

performing (604) a parameter fitting to the seed OCV equation using an optimization algorithm for fitting the set of parameters to obtain an initialized set of parameter values corresponding to the set of parameters;

identifying (606) a set of sensitive parameters from among the set of parameters by performing a sensitivity analysis on a measured discharge profile and a predicted discharge profile from the PBM model, wherein the sensitivity analysis is performed if a difference between the measured discharge profile and the predicted discharge profile is exceeding a predefined threshold;

fitting (608) the identified set of sensitive parameters to the seed OCV equation to determine a change in one or more of the sensitive parameters, wherein the determined change is represented using a linear equation; and

obtaining (610) the dynamic OCV equation using the linear equation and the seed OCV equation after fitting the identified set of sensitive parameters.

2. The processor implemented method as claimed in claim 1 comprises updating a set of data based models in an online module of the battery using the predicted set of state variables, wherein the set of data based models predicts in real time a set of real time state variables.

3. The processor implemented method as claimed in claim 1, wherein the battery specific information received as input data comprises of a) electrode chemistry, b) electrolyte chemistry, c) operating voltage range, d) operating temperature range, e) operating pressure range, f) an initial State of Charge (SOC), and g) an influential degradation mechanism associated with the battery.

4. The processor implemented method as claimed in claim 1, wherein the pre-processing of the input data is done using a plurality of pre-processing techniques comprising data cleaning, outlier detection, and data imputation.

5. The processor implemented method as claimed in claim 1, wherein the set of features generated from the preprocessed data comprises of anode material, cathode material, electrolyte material, operating voltage range, operating temperature range, and operating pressure range.

6. The processor implemented method as claimed in claim 1, wherein the major criteria is based on one or more dominant physical or chemical process inside the battery, and wherein one or more mechanistic and data-based models matching the major criteria of the battery are selected.

7. A system (100), comprising:

one or more hardware processors (402);
a communication interface (412); and
a memory (404) storing a plurality of instructions, wherein the plurality of instructions cause the one or more hardware processors to:

receive an input data comprising a battery specific information with respect to a battery;
pre-process the input data to generate a pre-processed data;
generate a set of features from the pre-processed data;
create a battery profile, by mapping the pre-processed data to the set of features,
select one or more models from a plurality of mechanistic and data-based models in a repository, wherein the one or more models are selected based on a major criterion and data in the battery profile;
generate a physics based model (PBM) from an output data obtained from the selected one or more models;
generate a set of state variables representing degradation of the battery, using the generated PBM model, wherein the set of variables comprise of state-of-charge (SoC), state-of-health (SoH), remaining useful life (RUL) and a set of dynamic variables, and the set of dynamic variables comprises of a discharge profile, capacity fade, one or more concentration profiles, film resistances, change in diffusivity, change in volume fraction of active material, change in internal temperature, change in material properties, and Open-Circuit Voltage (OCV), the one or more hardware processors are configured to predict the OCV using a dynamic OCV equation generated via the one or more hardware processors,
**characterised in that**:
the one or more hardware processors are configured to generate the dynamic OCV equation by:

receiving a) an initial OCV data related to the battery, and b) a seed OCV equation with a set of parameters related to the initial OCV data, wherein the set of parameters are obtained from a knowledge library;

performing a parameter fitting to the seed OCV equation using an optimization algorithm for fitting the set of parameters to obtain an initialized set of parameter values corresponding to the set of parameters; identifying a set of sensitive parameters from among the set of parameters by performing a sensitivity analysis on a measured discharge profile and a predicted discharge profile from the PBM model, wherein the sensitivity analysis is performed if a difference between the measured discharge profile and the predicted discharge profile is exceeding a predefined threshold;

fitting the identified set of sensitive parameters to the seed OCV equation to determine a change in one or more of the sensitive parameters, wherein the determined change is represented using a linear equation; and

obtaining the dynamic OCV equation using the linear equation and the seed OCV equation after fitting the identified set of sensitive parameters.

8. The system as claimed in claim 7, wherein the one or more hardware processors are configured to update a set of data based models in an online module of the battery using the predicted set of state variables, wherein the set of data based models predicts in real time a set of real time state variables.

9. The system as claimed in claim 7, wherein the battery specific information received as input data comprises of a) electrode chemistry, b) electrolyte chemistry, c) operating voltage range, d) operating temperature range, e) operating pressure range, f) an initial State of Charge (SOC), and g) an influential degradation mechanism associated with the battery.

10. The system as claimed in claim 7, wherein the one or more hardware processors are configured to pre-process the input data using a plurality of pre-processing techniques comprising data cleaning, outlier detection, and data imputation.

11. The system as claimed in claim 7, wherein the set of features generated from the preprocessed data comprises of anode material, cathode material, electrolyte material, operating voltage range, operating temperature range, and operating pressure range.

12. The system as claimed in claim 7, wherein the major criteria is based on one or more dominant physical or chemical process inside the battery, and wherein one or more mechanistic and data-based models matching the major criteria of the battery are selected.

13. One or more non-transitory machine-readable information storage mediums comprising one or more instructions which when executed by one or more hardware processors cause:

receiving an input data comprising a battery specific information with respect to a battery;
pre-processing the input data to generate a pre-processed data;
generating a set of features from the pre-processed data;
creating a battery profile by mapping the pre-processed data to the set of features,
selecting one or more models from a plurality of mechanistic and data-based models in a repository, wherein the one or more models are selected based on a major criterion and data in the battery profile;
generating a physics based model (PBM) from an output data obtained from the selected one or more models; and
generating a set of state variables representing degradation of the battery using the generated PBM model, wherein, the set of state variables comprise of state-of-charge (SoC), state-of-health (SoH), remaining useful life (RUL) and a set of dynamic variables, and the set of dynamic variables comprises of a discharge profile, capacity fade, one or more concentration profiles, film resistances, change in diffusivity, change in volume fraction of active material, change in internal temperature,
change in material properties, and Open-Circuit Voltage (OCV), wherein the OCV is predicted using a dynamic OCV equation generated via the one or more hardware processors, **characterised in that**: generating the dynamic OCV equation comprises:

receiving (602) a) an initial OCV data related to the battery, and b) a seed OCV equation with a set of parameters related to the initial OCV data, wherein the set of parameters are obtained from a knowledge library;

performing (604) a parameter fitting to the seed OCV equation using an optimization algorithm for fitting the set of parameters to obtain an initialized set of parameter values corresponding to the set of parameters;

identifying (606) a set of sensitive parameters from among the set of parameters by performing a sensitivity analysis on a measured discharge profile and a predicted discharge profile from the PBM model, wherein the sensitivity analysis is performed if a difference between the measured discharge profile and the predicted discharge profile is exceeding a predefined threshold;

fitting (608) the identified set of sensitive parameters to the seed OCV equation to determine a change in one or more of the sensitive parameters, wherein the determined change is represented using a linear equation; and

obtaining (610) the dynamic OCV equation using the linear equation and the seed OCV equation after fitting the identified set of sensitive parameters.

## Patentansprüche

1. Prozessorimplementiertes Verfahren (500), umfassend:

Empfangen (502), über einen oder mehrere Hardwareprozessoren, von Eingabedaten, die batteriespezifische Informationen in Bezug auf eine Batterie umfassen;

Vorverarbeiten (504), über den einen oder die mehreren Hardwareprozessoren, der Eingabedaten, um vorverarbeitete Daten zu erzeugen; Erzeugen (506), über den einen oder die mehreren Hardwareprozessoren, eines Satzes von Merkmalen aus den vorverarbeiteten Daten;

Erzeugen (508), über den einen oder die mehreren Hardwareprozessoren, eines Batterieprofils durch Abbilden der vorverarbeiteten Daten auf den Satz von Merkmalen,

Auswählen (510), über den einen oder die mehreren Hardwareprozessoren, eines oder mehrerer Modelle aus einer Mehrzahl von mechanistischen und datenbasierten Modellen in einem Repository, wobei das eine oder die mehreren Modelle basierend auf einem Hauptkriterium und Daten in dem Batterieprofil ausgewählt werden;

Erzeugen (512), über den einen oder die mehreren Hardwareprozessoren, eines physikbasierten Modells (PBM) aus Ausgabedaten, die aus dem ausgewählten einen oder den ausgewählten mehreren Modellen erhalten werden; und

Erzeugen eines Satzes von Zustandsvariablen, die eine Verschlechterung der Batterie darstellen, unter Verwendung des erzeugten PBM-Modells, wobei der Satz von Zustandsvariablen einen Ladezustand (SoC), einen Gesundheitszustand (SoH), eine verbleibende Nutzungsdauer (RUL) und einen Satz von dynamischen Variablen umfasst und der Satz von dynamischen Variablen ein Entladungsprofil, einen Kapazitätsschwund, ein oder mehrere Konzentrationsprofile, Filmwiderstände, eine Änderung der Diffusivität, eine Änderung des Volumenanteils des aktiven Materials, eine Änderung der Innentemperatur, eine Änderung der Materialeigenschaften und eine Leerlaufspannung (OCV) umfasst, wobei die OCV unter Verwendung einer dynamischen OCV-Gleichung vorhergesagt wird, die über den einen oder die mehreren Hardwareprozessoren erzeugt wird, **dadurch gekennzeichnet, dass**: das Erzeugen der dynamischen OCV-Gleichung Folgendes umfasst:

Empfangen (602) a) von anfänglichen OCV-Daten, die sich auf die Batterie beziehen, und b) einer Ausgangs-OCV-Gleichung mit einem Satz von Parametern, die sich auf die anfänglichen OCV-Daten beziehen, wobei der Satz von Parametern aus einer Wissensbibliothek erhalten wird;

Durchführen (604) einer Parameteranpassung an die Ausgangs-OCV-Gleichung unter Verwendung eines Optimierungsalgorithmus zum Anpassen des Satzes von Parametern, um einen initialisierten Satz von Parameterwerten zu erhalten, die dem Satz von Parametern entsprechen;

Identifizieren (606) eines Satzes von empfindlichen Parametern aus dem Satz von Parametern durch Durchführen einer Empfindlichkeitsanalyse an einem gemessenen Entladungsprofil und einem vorhergesagten Entladungsprofil aus dem PBM-Modell, wobei die Empfindlichkeitsanalyse durchgeführt wird, wenn eine Differenz zwischen dem gemessenen Entladungsprofil und dem vorhergesagten Entladungsprofil einen vordefinierten Schwellenwert überschreitet;

Anpassen (608) des identifizierten Satzes von empfindlichen Parametern an die Ausgangs-OCV-Gleichung, um eine Änderung in einem oder mehreren der empfindlichen Parameter zu bestimmen, wobei die bestimmte Änderung unter Verwendung einer linearen Gleichung dargestellt wird; und

Erhalten (610) der dynamischen OCV-Gleichung unter Verwendung der linearen Gleichung und der Ausgangs-OCV-Gleichung nach dem Anpassen des identifizierten Satzes von empfindlichen Parametern.

2. Prozessorimplementiertes Verfahren nach Anspruch 1, umfassend das Aktualisieren eines Satzes von datenbasierten Modellen in einem Online-Modul der Batterie unter Verwendung des vorhergesagten Satzes von Zustandsvariablen, wobei der Satz von datenbasierten Modellen in Echtzeit einen Satz von Echtzeit-Zustandsvariablen vorhersagt.

3. Prozessorimplementiertes Verfahren nach Anspruch 1, wobei die batteriespezifischen Informationen, die als Eingabedaten empfangen werden, Folgendes umfassen: a) Elektrodenchemie, b) Elektrolytchemie, c) Betriebsspannungsbereich, d) Betriebstemperaturbereich, e) Betriebsdruckbereich, f) einen anfänglichen Ladezustand (state of charge - SOC) und g) einen einflussreichen Verschlechterungsmechanismus, der der Batterie zugeordnet ist.

4. Prozessorimplementiertes Verfahren nach Anspruch 1, wobei die Vorverarbeitung der Eingabedaten unter Verwendung einer Mehrzahl von Vorverarbeitungstechniken erfolgt, die Datenbereinigung, Ausreißerdetektion und Datenzuordnung umfassen.

5. Prozessorimplementiertes Verfahren nach Anspruch 1, wobei der Satz von Merkmalen, der aus den vorverarbeiteten Daten erzeugt wird, Folgendes umfasst: Anodenmaterial, Kathodenmaterial, Elektrolytmaterial, Betriebsspannungsbereich, Betriebstemperaturbereich und Betriebsdruckbereich.

6. Prozessorimplementiertes Verfahren nach Anspruch 1, wobei das Hauptkriterium auf einem oder mehreren dominanten physikalischen oder chemischen Prozessen innerhalb der Batterie basiert und wobei ein oder mehrere mechanistische und datenbasierte Modelle, die mit den Hauptkriterien der Batterie übereinstimmen, ausgewählt werden.

7. System (100), umfassend:

    einen oder mehrere Hardwareprozessoren (402);
    eine Kommunikationsschnittstelle (412); und
    einen Speicher (404), der eine Mehrzahl von Anweisungen speichert, wobei die Mehrzahl von Anweisungen den einen oder die mehreren Hardwareprozessoren zu Folgendem veranlasst:

        Empfangen von Eingabedaten, die batteriespezifische Informationen in Bezug auf eine Batterie umfassen;
        Vorverarbeiten der Eingabedaten, um vorverarbeitete Daten zu erzeugen;
        Erzeugen eines Satzes von Merkmalen aus den vorverarbeiteten Daten;
        Erzeugen eines Batterieprofils durch Abbilden der vorverarbeiteten Daten auf den Satz von Merkmalen, Auswählen eines oder mehrerer Modelle aus einer Mehrzahl von mechanistischen und datenbasierten Modellen in einem Repository, wobei das eine oder die mehreren Modelle basierend auf einem Hauptkriterium und Daten in dem Batterieprofil ausgewählt werden;
        Erzeugen eines physikbasierten Modells (PBM) aus Ausgabedaten, die aus dem ausgewählten einen oder den ausgewählten mehreren Modellen erhalten werden;
        Erzeugen eines Satzes von Zustandsvariablen, die eine Verschlechterung der Batterie darstellen, unter Verwendung des erzeugten PBM-Modells, wobei der Satz von Variablen einen Ladezustand (SoC), einen Gesundheitszustand (SoH), eine verbleibende Nutzungsdauer (RUL) und einen Satz von dynamischen Variablen umfasst und der Satz von dynamischen Variablen ein Entladungsprofil, einen Kapazitätsschwund, ein oder mehrere Konzentrationsprofile, Filmwiderstände, eine Änderung der Diffusivität, eine Änderung des Volumenanteils des aktiven Materials, eine Änderung der Innentemperatur, eine Änderung der Materialeigenschaften und eine Leerlaufspannung (OCV) umfasst, wobei der eine oder die mehreren Hardwareprozessoren konfiguriert sind, um die OCV unter Verwendung einer dynamischen OCV-Gleichung vorherzusagen, die über den einen oder die mehreren Hardwareprozessoren erzeugt wird, **dadurch gekennzeichnet,**
        **dass**: der eine oder die mehreren Hardwareprozessoren konfiguriert sind, um die dynamische OCV-Gleichung durch Folgendes zu erzeugen:

            Empfangen a) von anfänglichen OCV-Daten, die sich auf die Batterie beziehen, und b) einer Ausgangs-OCV-Gleichung mit einem Satz von Parametern, die sich auf die anfänglichen OCV-Daten beziehen, wobei der Satz von Parametern aus einer Wissensbibliothek erhalten wird;
            Durchführen einer Parameteranpassung an die Ausgangs-OCV-Gleichung unter Verwendung eines Optimierungsalgorithmus zum Anpassen des Satzes von Parametern, um einen initialisierten Satz von Parameterwerten zu erhalten, die dem Satz von Parametern entsprechen;

Identifizieren eines Satzes von empfindlichen Parametern aus dem Satz von Parametern durch Durchführen einer Empfindlichkeitsanalyse an einem gemessenen Entladungsprofil und einem vorhergesagten Entladungsprofil aus dem PBM-Modell, wobei die Empfindlichkeitsanalyse durchgeführt wird, wenn eine Differenz zwischen dem gemessenen Entladungsprofil und dem vorhergesagten Entladungsprofil einen vordefinierten Schwellenwert überschreitet;

Anpassen des identifizierten Satzes von empfindlichen Parametern an die Ausgangs-OCV-Gleichung, um eine Änderung in einem oder mehreren der empfindlichen Parameter zu bestimmen, wobei die bestimmte Änderung unter Verwendung einer linearen Gleichung dargestellt wird; und

Erhalten der dynamischen OCV-Gleichung unter Verwendung der linearen Gleichung und der Ausgangs-OCV-Gleichung nach dem Anpassen des identifizierten Satzes von empfindlichen Parametern.

8. System nach Anspruch 7, wobei der eine oder die mehreren Hardwareprozessoren konfiguriert sind, um einen Satz von datenbasierten Modellen in einem Online-Modul der Batterie unter Verwendung des vorhergesagten Satzes von Zustandsvariablen zu aktualisieren, wobei der Satz von datenbasierten Modellen in Echtzeit einen Satz von Echtzeit-Zustandsvariablen vorhersagt.

9. System nach Anspruch 7, wobei die batteriespezifischen Informationen, die als Eingabedaten empfangen werden, Folgendes umfassen: a) Elektrodenchemie, b) Elektrolytchemie, c) Betriebsspannungsbereich, d) Betriebstemperaturbereich, e) Betriebsdruckbereich, f) einen anfänglichen Ladezustand (state of charge - SOC) und g) einen einflussreichen Verschlechterungsmechanismus, der der Batterie zugeordnet ist.

10. System nach Anspruch 7, wobei der eine oder die mehreren Hardwareprozessoren konfiguriert sind, um die Eingabedaten unter Verwendung einer Mehrzahl von Vorverarbeitungstechniken vorzuverarbeiten, die Datenbereinigung, Ausreißerdetektion und Datenzuordnung umfassen.

11. System nach Anspruch 7, wobei der Satz von Merkmalen, der aus den vorverarbeiteten Daten erzeugt wird, Folgendes umfasst: Anodenmaterial, Kathodenmaterial, Elektrolytmaterial, Betriebsspannungsbereich, Betriebstemperaturbereich und Betriebsdruckbereich.

12. System nach Anspruch 7, wobei das Hauptkriterium auf einem oder mehreren dominanten physikalischen oder chemischen Prozessen innerhalb der Batterie basiert und wobei ein oder mehrere mechanistische und datenbasierte Modelle, die mit den Hauptkriterien der Batterie übereinstimmen, ausgewählt werden.

13. Ein oder mehrere nichtflüchtige maschinenlesbare Informationsspeichermedien, die eine oder mehrere Anweisungen umfassen, die bei Ausführung durch einen oder mehrere Hardwareprozessoren Folgendes veranlassen:

Empfangen von Eingabedaten, die batteriespezifische Informationen in Bezug auf eine Batterie umfassen;
Vorverarbeiten der Eingabedaten, um vorverarbeitete Daten zu erzeugen;
Erzeugen eines Satzes von Merkmalen aus den vorverarbeiteten Daten; Erzeugen eines Batterieprofils durch Abbilden der vorverarbeiteten Daten auf den Satz von Merkmalen,
Auswählen eines oder mehrerer Modelle aus einer Mehrzahl von mechanistischen und datenbasierten Modellen in einem Repository, wobei das eine oder die mehreren Modelle basierend auf einem Hauptkriterium und Daten in dem Batterieprofil ausgewählt werden;
Erzeugen eines physikbasierten Modells (PBM) aus Ausgabedaten, die aus dem ausgewählten einen oder den ausgewählten mehreren Modellen erhalten werden; und
Erzeugen eines Satzes von Zustandsvariablen, die eine Verschlechterung der Batterie darstellen, unter Verwendung des erzeugten PBM-Modells, wobei der Satz von Zustandsvariablen einen Ladezustand (SoC), einen Gesundheitszustand (SoH), eine verbleibende Nutzungsdauer (RUL) und einen Satz von dynamischen Variablen umfasst und der Satz von dynamischen Variablen ein Entladungsprofil, einen Kapazitätsschwund, ein oder mehrere Konzentrationsprofile, Filmwiderstände, eine Änderung der Diffusivität, eine Änderung des Volumenanteils des aktiven Materials, eine Änderung der Innentemperatur, eine Änderung der Materialeigenschaften und eine Leerlaufspannung (OCV) umfasst, wobei die OCV unter Verwendung einer dynamischen OCV-Gleichung vorhergesagt wird, die über den einen oder die mehreren Hardwareprozessoren erzeugt wird, **dadurch gekennzeichnet, dass**: das Erzeugen der dynamischen OCV-Gleichung Folgendes umfasst:

Empfangen (602) a) von anfänglichen OCV-Daten, die sich auf die Batterie beziehen, und b) einer Ausgangs-OCV-Gleichung mit einem Satz von Parametern, die sich auf die anfänglichen OCV-Daten beziehen, wobei der Satz von Parametern aus einer Wissensbibliothek erhalten wird;

Durchführen (604) einer Parameteranpassung an die Ausgangs-OCV-Gleichung unter Verwendung eines Optimierungsalgorithmus zum Anpassen des Satzes von Parametern, um einen initialisierten Satz von Parameterwerten zu erhalten, die dem Satz von Parametern entsprechen;

Identifizieren (606) eines Satzes von empfindlichen Parametern aus dem Satz von Parametern durch Durchführen einer Empfindlichkeitsanalyse an einem gemessenen Entladungsprofil und einem vorhergesagten Entladungsprofil aus dem PBM-Modell, wobei die Empfindlichkeitsanalyse durchgeführt wird, wenn eine Differenz zwischen dem gemessenen Entladungsprofil und dem vorhergesagten Entladungsprofil einen vordefinierten Schwellenwert überschreitet;

Anpassen (608) des identifizierten Satzes von empfindlichen Parametern an die Ausgangs-OCV-Gleichung, um eine Änderung in einem oder mehreren der empfindlichen Parameter zu bestimmen, wobei die bestimmte Änderung unter Verwendung einer linearen Gleichung dargestellt wird; und

Erhalten (610) der dynamischen OCV-Gleichung unter Verwendung der linearen Gleichung und der Ausgangs-OCV-Gleichung nach dem Anpassen des identifizierten Satzes von empfindlichen Parametern.

**Revendications**

1. Procédé mis en œuvre par processeur (500), comprenant :

   la réception (502), via un ou plusieurs processeurs matériels, de données d'entrée comprenant des informations spécifiques à la batterie par rapport à une batterie ;
   le prétraitement (504), via les un ou plusieurs processeurs matériels, des données d'entrée pour générer des données prétraitées ;
   la génération (506), via les un ou plusieurs processeurs matériels, d'un ensemble de caractéristiques à partir des données prétraitées ;
   la création (508), via les un ou plusieurs processeurs matériels, d'un profil de batterie, en mettant en correspondance les données prétraitées avec l'ensemble de caractéristiques ;
   la sélection (510), via les un ou plusieurs processeurs matériels, d'un ou plusieurs modèles parmi une pluralité de modèles mécanistes et basés sur des données dans un référentiel, dans lequel les un ou plusieurs modèles sont sélectionnés sur la base d'un critère majeur et de données dans le profil de batterie ;
   la génération (512), via les un ou plusieurs processeurs matériels, d'un modèle basé sur la physique (PBM) à partir de données de sortie obtenues à partir des un ou plusieurs modèles sélectionnés ; et
   la génération d'un ensemble de variables d'état représentant une dégradation de la batterie à l'aide du modèle PBM généré, dans lequel l'ensemble de variables d'état comprend un état de charge (SoC), un état de santé (SoH), une durée de vie utile restante (RUL) et un ensemble de variables dynamiques, et l'ensemble de variables dynamiques comprend un profil de décharge, un affaiblissement de capacité, un ou plusieurs profils de concentration, des résistances de film, un changement de diffusivité, un changement de fraction volumique de matériau actif, un changement de température interne, un changement de propriétés de matériau, et une tension en circuit ouvert (OCV), dans lequel l'OCV est prédite à l'aide d'une équation OCV dynamique générée via les un ou plusieurs processeurs matériels, **caractérisé en ce que** :
   la génération de l'équation OCV dynamique comprend :

   la réception (602) a) de données OCV initiales liées à la batterie, et b) d'une équation OCV de départ avec un ensemble de paramètres liés aux données OCV initiales, dans lequel l'ensemble de paramètres est obtenu à partir d'une bibliothèque de connaissances ;
   la réalisation (604) d'un ajustement de paramètre à l'équation OCV de départ à l'aide d'un algorithme d'optimisation pour ajuster l'ensemble de paramètres afin d'obtenir un ensemble initialisé de valeurs de paramètre correspondant à l'ensemble de paramètres ;
   l'identification (606) d'un ensemble de paramètres sensibles parmi l'ensemble de paramètres en réalisant une analyse de sensibilité sur un profil de décharge mesuré et un profil de décharge prédit à partir du modèle PBM, dans lequel l'analyse de sensibilité est réalisée si une différence entre le profil de décharge mesuré et le profil de décharge prédit dépasse un seuil prédéfini ;
   l'ajustement (608) de l'ensemble identifié de paramètres sensibles à l'équation OCV de départ afin de déterminer un changement dans un ou plusieurs des paramètres sensibles, dans lequel le changement déterminé est représenté à l'aide d'une équation linéaire ; et
   l'obtention (610) de l'équation OCV dynamique à l'aide de l'équation linéaire et de l'équation OCV de départ après ajustement de l'ensemble identifié de paramètres sensibles.

**2.** Procédé mis en œuvre par processeur selon la revendication 1, comprenant la mise à jour d'un ensemble de modèles basés sur des données dans un module en ligne de la batterie à l'aide de l'ensemble prédit de variables d'état, dans lequel l'ensemble de modèles basés sur des données prédit en temps réel un ensemble de variables d'état en temps réel.

**3.** Procédé mis en œuvre par processeur selon la revendication 1, dans lequel les informations spécifiques à la batterie reçues en tant que données d'entrée comprennent a) une chimie des électrodes, b) une chimie des électrolytes, c) une plage de tensions de fonctionnement, d) une plage de températures de fonctionnement, e) une plage de pressions de fonctionnement, f) un état de charge initial (SOC), et g) un mécanisme de dégradation influent associé à la batterie.

**4.** Procédé mis en œuvre par processeur selon la revendication 1, dans lequel le prétraitement des données d'entrée est réalisé à l'aide d'une pluralité de techniques de prétraitement comprenant un nettoyage de données, une détection des valeurs aberrantes, et une imputation de données.

**5.** Procédé mis en œuvre par processeur selon la revendication 1, dans lequel l'ensemble de caractéristiques généré à partir des données prétraitées comprend un matériau d'anode, un matériau de cathode, un matériau d'électrolyte, une plage de tensions de fonctionnement, une plage de températures de fonctionnement, et une plage de pressions de fonctionnement.

**6.** Procédé mis en œuvre par processeur selon la revendication 1, dans lequel le critère majeur est basé sur un ou plusieurs processus physiques ou chimiques dominants à l'intérieur de la batterie, et dans lequel un ou plusieurs modèles mécanistes et basés sur des données correspondant aux critères majeurs de la batterie sont sélectionnés.

**7.** Système (100), comprenant :

un ou plusieurs processeurs matériels (402) ;
une interface de communication (412) ; et
une mémoire (404) stockant une pluralité d'instructions, dans lequel la pluralité d'instructions amènent les un ou plusieurs processeurs matériels à :

recevoir des données d'entrée comprenant des informations spécifiques à la batterie par rapport à une batterie ;
prétraiter les données d'entrée pour générer des données prétraitées ;
générer un ensemble de caractéristiques à partir des données prétraitées ;
créer un profil de batterie, en mettant en correspondance les données prétraitées avec l'ensemble de caractéristiques ;
sélectionner un ou plusieurs modèles parmi une pluralité de modèles mécanistes et basés sur des données dans un référentiel, dans lequel les un ou plusieurs modèles sont sélectionnés sur la base d'un critère majeur et de données dans le profil de batterie;
générer un modèle basé sur la physique (PBM) à partir de données de sortie obtenues à partir des un ou plusieurs modèles sélectionnés ;
générer un ensemble de variables d'état représentant une dégradation de la batterie, à l'aide du modèle PBM généré, dans lequel l'ensemble de variables comprend un état de charge (SoC), un état de santé (SoH), une durée de vie utile restante (RUL) et un ensemble de variables dynamiques, et l'ensemble de variables dynamiques comprend un profil de décharge, un affaiblissement de capacité, un ou plusieurs profils de concentration, des résistances de film, un changement de diffusivité, un changement de fraction volumique de matériau actif, un changement de température interne, un changement de propriétés de matériau, et une tension en circuit ouvert (OCV), les un ou plusieurs processeurs matériels sont configurés pour prédire l'OCV à l'aide d'une équation OCV dynamique générée via les un ou plusieurs processeurs matériels, **caractérisé en ce que** :
les un ou plusieurs processeurs matériels sont configurés pour générer l'équation OCV dynamique par :

la réception a) de données OCV initiales liées à la batterie, et b) d'une équation OCV de départ avec un ensemble de paramètres liés aux données OCV initiales, dans lequel l'ensemble de paramètres est obtenu à partir d'une bibliothèque de connaissances ;
la réalisation d'un ajustement de paramètre à l'équation OCV de départ à l'aide d'un algorithme d'optimisation pour ajuster l'ensemble de paramètres afin d'obtenir un ensemble initialisé de valeurs de paramètre correspondant à l'ensemble de paramètres ;

l'identification d'un ensemble de paramètres sensibles parmi l'ensemble de paramètres en réalisant une analyse de sensibilité sur un profil de décharge mesuré et un profil de décharge prédit à partir du modèle PBM, dans lequel l'analyse de sensibilité est réalisée si une différence entre le profil de décharge mesuré et le profil de décharge prédit dépasse un seuil prédéfini ;

l'ajustement de l'ensemble identifié de paramètres sensibles à l'équation OCV de départ afin de déterminer un changement dans un ou plusieurs des paramètres sensibles, dans lequel le changement déterminé est représenté à l'aide d'une équation linéaire ; et

l'obtention de l'équation OCV dynamique à l'aide de l'équation linéaire et de l'équation OCV de départ après ajustement de l'ensemble identifié de paramètres sensibles.

8. Système selon la revendication 7, dans lequel les un ou plusieurs processeurs matériels sont configurés pour mettre à jour un ensemble de modèles basés sur des données dans un module en ligne de la batterie à l'aide de l'ensemble prédit de variables d'état, dans lequel l'ensemble de modèles basés sur des données prédit en temps réel un ensemble de variables d'état en temps réel.

9. Système selon la revendication 7, dans lequel les informations spécifiques à la batterie reçues en tant que données d'entrée comprennent a) une chimie des électrodes, b) une chimie des électrolytes, c) une plage de tensions de fonctionnement, d) une plage de températures de fonctionnement, e) une plage de pressions de fonctionnement, f) un état de charge initial (SOC), et g) un mécanisme de dégradation influent associé à la batterie.

10. Système selon la revendication 7, dans lequel les un ou plusieurs processeurs matériels sont configurés pour prétraiter les données d'entrée à l'aide d'une pluralité de techniques de prétraitement comprenant un nettoyage de données, une détection des valeurs aberrantes, et une imputation de données.

11. Système selon la revendication 7, dans lequel l'ensemble de caractéristiques généré à partir des données prétraitées comprend un matériau d'anode, un matériau de cathode, un matériau d'électrolyte, une plage de tensions de fonctionnement, une plage de températures de fonctionnement, et une plage de pressions de fonctionnement.

12. Système selon la revendication 7, dans lequel le critère majeur est basé sur un ou plusieurs processus physiques ou chimiques dominants à l'intérieur de la batterie, et dans lequel un ou plusieurs modèles mécanistes et basés sur des données correspondant aux critères majeurs de la batterie sont sélectionnés.

13. Un ou plusieurs supports de stockage d'informations lisibles par machine non transitoires comprenant une ou plusieurs instructions qui, lorsqu'elles sont exécutées par un ou plusieurs processeurs matériels, amènent :

la réception de données d'entrée comprenant des informations spécifiques à la batterie par rapport à une batterie ;

le prétraitement des données d'entrée pour générer des données prétraitées ;

la génération d'un ensemble de caractéristiques à partir des données prétraitées ;

la création d'un profil de batterie en mettant en correspondance les données prétraitées avec l'ensemble de caractéristiques ;

la sélection d'un ou plusieurs modèles parmi une pluralité de modèles mécanistes et basés sur des données dans un référentiel, dans lequel les un ou plusieurs modèles sont sélectionnés sur la base d'un critère majeur et de données dans le profil de batterie ;

la génération d'un modèle basé sur la physique (PBM) à partir de données de sortie obtenues à partir des un ou plusieurs modèles sélectionnés ; et

la génération d'un ensemble de variables d'état représentant une dégradation de la batterie à l'aide du modèle PBM généré, dans lequel l'ensemble de variables d'état comprend un état de charge (SoC), un état de santé (SoH), une durée de vie utile restante (RUL) et un ensemble de variables dynamiques, et l'ensemble de variables dynamiques comprend un profil de décharge, un affaiblissement de capacité, un ou plusieurs profils de concentration, des résistances de film, un changement de diffusivité, un changement de fraction volumique de matériau actif, un changement de température interne, un changement de propriétés de matériau, et une tension en circuit ouvert (OCV), dans lequel l'OCV est prédite à l'aide d'une équation OCV dynamique générée via les un ou

plusieurs processeurs matériels, **caractérisé en ce que** :

la génération de l'équation OCV dynamique comprend :

la réception (602) a) de données OCV initiales liées à la batterie, et b) d'une équation OCV de départ avec un ensemble de paramètres liés aux données OCV initiales, dans lequel l'ensemble de paramètres est obtenu à partir d'une bibliothèque de connaissances ;

la réalisation (604) d'un ajustement de paramètre à l'équation OCV de départ à l'aide d'un algorithme d'optimisation pour ajuster l'ensemble de paramètres afin d'obtenir un ensemble initialisé de valeurs de paramètre correspondant à l'ensemble de paramètres ;

l'identification (606) d'un ensemble de paramètres sensibles parmi l'ensemble de paramètres en réalisant une analyse de sensibilité sur un profil de décharge mesuré et un profil de décharge prédit à partir du modèle PBM, dans lequel l'analyse de sensibilité est réalisée si une différence entre le profil de décharge mesuré et le profil de décharge prédit dépasse un seuil prédéfini ;

l'ajustement (608) de l'ensemble identifié de paramètres sensibles à l'équation OCV de départ afin de déterminer un changement dans un ou plusieurs des paramètres sensibles, dans lequel le changement déterminé est représenté à l'aide d'une équation linéaire ; et

l'obtention (610) de l'équation OCV dynamique à l'aide de l'équation linéaire et de l'équation OCV de départ après ajustement de l'ensemble identifié de paramètres sensibles.

FIG. 1

Pre-processed data

Offline
Module

Updated models

BMS → Data → Data Receiving module → Data pre-processing module → Data-based model

Data-based model ← Optimization Module

Optimization Module → Control Module

Control Module → Recommendations → BMS

Online module 101

FIG. 2

FIG. 3

100

MEMORY 404

MODULES 406

REPOSITORY 410

408

I/O INTERFACE 412

HARDWARE PROCESSORS 402

FIG. 4

502

receiving, via one or more hardware processors, an input data comprising a battery specific information with respect to a battery

504

pre-processing, via the one or more hardware processors, the input data to generate a pre-processed data

506

generating, via the one or more hardware processors, a set of features from the pre-processed data

508

creating, via the one or more hardware processors, a battery profile, by mapping the pre-processed data to the set of features

510

selecting, via the one or more hardware processors, one or more models from a plurality of mechanistic and data-based models in a repository, wherein the one or more models are selected based on a major criterion

512

generating, via the one or more hardware processors, a physics based model (PBM) from an output data obtained from the selected one or more models

514

generating, via the one or more hardware processors, prediction of a set of state variables representing degradation of the battery, using the generated PBM model

FIG. 5

500

602

receiving a) an initial OCV data related to the battery, and b) a seed OCV equation with a set of parameters related to the initial OCV data, wherein the set of parameters are obtained from a knowledge library

604

performing a parameter fitting to the seed OCV equation using an optimization algorithm for fitting the set of parameters to obtain an initialized set of parameter values corresponding to the set of parameters

606

identifying a set of sensitive parameters from among the set of parameters by performing a sensitivity analysis on a measured discharge profile and a predicted discharge profile from the PBM model, wherein the sensitivity analysis is performed if a difference between the measured discharge profile and the predicted discharge profile is exceeding a predefined threshold

608

fitting the identified set of sensitive parameters to the seed OCV equation to determine a change in one or more of the sensitive parameters, wherein the determined change is represented using a linear equation

610

obtaining the dynamic OCV equation using the linear equation and the seed OCV equation after fitting the identified set of sensitive parameters

600

FIG. 6

FIG. 7

**EP 4 560 332 B1**

(a)

(b)

FIG. 8

28

(a)                (b)                (c)

FIG. 9

FIG. 10

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- IN 202321079447
- US 2022034974 A1